# EUROPÄISCHE PATENTANMELDUNG

(11) **EP 0 753 601 A2**
(43) Veröffentlichungstag der Anmeldung: **15.01.1997**
(21) Anmeldenummer: 95111291.1
(22) Anmeldetag: 19.07.1995
(51) Int. Cl.: C23C 14/56, C23C 14/34

(54) **Vorrichtung zum Beschichten**

(30) Priorität: 14.07.1995 DE 19500964
(71) Anmelder: Balzers und Leybold Deutschland Holding Aktiengesellschaft, 63450 Hanau (DE)
(72) Erfinder: Beisswenger, Siegfried, Dr., D - 63755 Alzenau (DE)

(57) **Zusammenfassung**

Bei einer Vorrichtung zum Beschichten mittels Kathodenzerstäubung von im wesentlichen flachen Substraten (11, 11',...),
mit mindestens einer evakuierbaren Vorkammer (3) und mindestens einer mit dieser über eine Schleuseneinrichtung (13) verbundene Prozeßkammer (4) und
mit mehreren in der Prozeßkammer (4) angeordneten Beschichtungsquellen (8, 9) und
mit einer Vorrichtung (12, 12',...) zum Transportieren der Substrate (11, 11',...) von einer Bereitstellungsstation (15) durch die Vorkammer (3) in die Prozeßkammer (4) und aus der Prozeßkammer (4) zurück durch die Vorkammer (3) zur Bereitstellungsstation (15)
ist eine Einrichtung vorgesehen zum Umschalten der Bewegungsrichtung der die Substrate (11,11',...) transportierenden Vorrichtung (12,12',...) um zwischen dem Einschleusen und dem Ausschleusen der Substrate ein mehrmaliges Passieren der Substrate (11, 11',...) der längs des Substrattransportweges in der Prozeßkammer (4) angeordneten Beschichtungsquellen (8, 9) zu bewirken.

## Beschreibung

Die Erfindung betrifft eine Vorrichtung zum Beschichten mittels Kathodenzerstäubung von im wesentlichen flachen Substraten, vorzugsweise von optischen Elementen.

Zum Stand der Technik sind Beschichtungsverfahren bekannt, beispielsweise auf dem Gebiet der Großflächen-Glasbeschichtung für ebene, plattenförmige Substrate, die überwiegend in Durchlauf- oder sogenannten "Inline"-Anlagen stattfinden. Für die Beschichtung von Substraten mit unterschiedlichen Werkstoffen oder auch für die Aufbringung verschiedenartige Schichtsysteme müssen die Beschichtungsanlagen so flexibel wie möglich ausgelegt sein und besitzen daher meist mehrere Zerstäubungskathoden.

Um Zerstäubungskathoden, die in unterschiedlicher Gasatmosphäre betrieben werden, sicher voneinander trennen zu können und störende Gasüberströmungen zu vermeiden, werden Schlitzschleusen oder Drehschleusen verwendet (DE-OS 42 03 473).

Dieses "Gastrennprinzip" kann für flache Substrate verwirklicht werde. Für großflächige gebogene Substrate, z. B. Bildröhren mit unterschiedlichen Biegungen und Krümmungsradien muß zwischen parallel zu betreibenden Kathoden, die in unterschiedlichen Gasatmosphären arbeiten, eine sogenannte Bufferkammer mit zwei zusätzlichen Transferkammern eingesetzt werden. Die Bufferkammer schafft eine Gastrennung durch zwei Schleusenventile.

Bei Mehrschichtsystemen bedeutet dies, daß mehrere Gastrennkammern notwendig sind.

Als ökonomische Alternative hat sich daher für große gebogene Substrate der sogenannte "Multipass"-Anlagentyp durchgesetzt.

Die "Multipass"-Anlagen besitzen nur noch eine Zerstäubungskammer mit direkt nebeneinander angeordneten Kathoden und bauen dadurch wesentlich kleiner als vergleichbare Inline-Anlagen. In einer "Multipass"-Anlage passiert das zu beschichtende Substrat definitionsgemäß mehrmals die Zerstäubungskammer.

Da die oben genannten Beschichtungsanlagen üblicherweise zur Herstellung von Massengütern im Dauerbetrieb eingesetzt sind und die Herstellkosten bei diesen Gütern einen nicht unerheblichen Einflußfaktor darstellen, suchte man nach Sparmaßnahmen und Möglichkeiten die Produktivität zu steigern und die Taktzeit des Multipassverfahrens zu senken, d. h. den Durchsatz an Substraten pro Zeiteinheit zu erhöhen.

Man hat deshalb auch schon vorgeschlagen, (DE-OS 41 11 384) die zu beschichtenden Substrate bzw. die die Substrate aufnehmenden Substrathalter vor dem Eintritt in die Zerstäubungskammer in Gruppen, vorzugsweise von je zwei oder auch mehreren Substraten bzw. Substrathaltern zusammenzufassen und diese, die Zerstäubungskammer gleichzeitig im sogenannten Dual-Multipass-Mode durchlaufen zu lassen.

Die bekannte Vorrichtung eignet sich hauptsächlich für die Bearbeitung von vergleichsweise großen Substraten und hat den Nachteil auch einen großen Platzbedarf zu erfordern, da sie als reine Durchlaufanlage mehrere der Zerstäubungskammer nachgeschaltete Transferkammern benötigt.

Der vorliegenden Erfindung liegt demgegenüber die Aufgabe zugrunde, eine Vorrichtung zu schaffen, die insbesondere für die Beschichtung von feinoptischen Elementen mit Mehrfachschichten geeignet ist (also für die Bearbeitung von Substraten kleinerer Abmessungen, wie z. B. Interferenzfiltern mit einer besonders großen Zahl von Schichten) bei der auf einem Substrathalter oder carrier eine vergleichsweise sehr große Zahl von Substraten angeordnet werden kann, die dann sämtlich in einer im Aufbau und in den Abmessungen vergleichsweise einfachen bzw. besonders platzsparenden Vorrichtung bearbeitbar sind.

Diese Aufgabe wird erfindungsgemäß durch eine Vorrichtung gelöst
mit mindesten einer evakuierbaren Vorkammer und mindestens einer mit dieser über eine Schleuseneinrichtung verbundene Prozeßkanmmer und
mit mehreren in der Prozeßkammer angeordneten Beschichtungsquellen und
mit einer Vorrichtung zum Transportieren der Substrate von einer Bereitstellungsstation durch die Vorkammer in die Prozeßkammer und aus der Prozeßkammer zurück durch die Vorkammer zur Bereitstellungsstation,
mit einer Einrichtung zum Umschalten der Bewegungsrichtung der die Substrate transportierenden Vorrichtung um zwischen dem Einschleusen und dem Ausschleusen der Substrate ein mehrmaliges Passieren der Substrate (im sogenannten Dual-Multipass-Mode) der längs des Substrattransportweges in der Prozeßkammer angeordneten Beschichtungsquellen zu bewirken.

Weitere Ausführungsmöglichkeiten und Merkmale sind in den Unteransprüchen näher beschrieben und gekennzeichnet.

Die Erfindung läßt verschiedenartige Ausführungsmöglichkeiten zu; eine davon ist in der anhängenden Zeichnung schematisch dargestellt.

Die Vorrichtung besteht aus einer evakuierbaren Vorkammer 3, einer mit dieser korrespondierenden Prozeßkammer 4, den mit den Kammern 3, 4 verbundenen Vakuumpumpen 5, 6, 7, den in der Prozeßkammer 4 angeordneten Magnetron-Kathoden 8, 9 die beide als Kathoden mit jeweils zwei Targets ausgebildet sind (sog. Twin-Mag's), dem Substrathalter 10 und einer nicht näher dargestellten Vorrichtung zum Transport des Substrathalters 10 durch die Kammern 3, 4. Die Transportvorrichtung kann aus einer Kette von Rollen 12, 12',... gebildet sein, die sämtlich elektromotorisch angetrieben sind und deren Drehsinn jeweils umschaltbar ist. Zwischen den beiden Kammern 3, 4 ist eine Schleuse 13 vorgesehen, die den Durchtritt des Substrathalters 10 von der Vorkammer 3 in die Prozeßkammer 4 und umgekehrt erlaubt. Darüber hinaus ist eine weitere Schleuse 14 in der Wand der Vorkammer 3 angeordnet, die den Eintritt des Substrathalters 10 von der Bereitstellungsstation 15 in die Vorkammer 3 bzw. aus dieser zurück in die Bereitstellungsstation 15 gestattet.

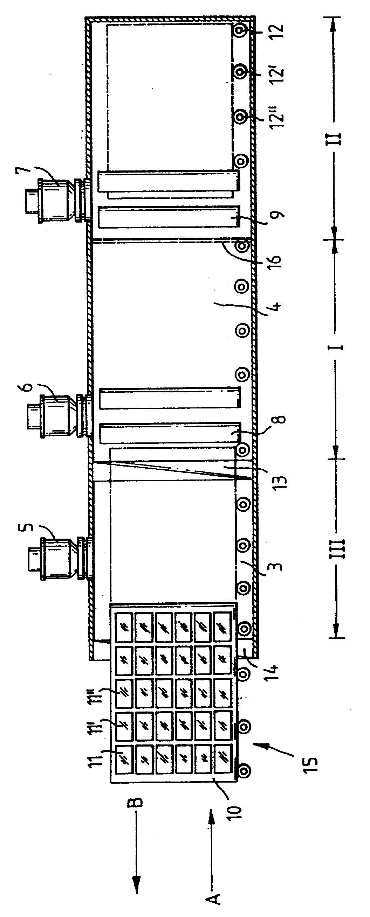

Bei Beginn des Beschichtungsprozesses wird der Substrathalter 10 mit den auf ihm befestigten Substraten 11, 11', 11'',... in Pfeilrichtung A durch die Schleuse 14 in die Vorkammer 3 bewegt. Nach dem die Vorkammer 3 einen Innendruck aufweist, der dem auch in der Prozeßkammer 4 herrschenden Prozeß-Druck entspricht, wird der Substrathalter 10 auf den Rollen 12, 12',... weiter in Richtung A bis in den ersten Abschnitt I der Prozeßkammer 4 transportiert, wobei beide Abschnitte I und II durch eine Blende oder eine Abschirmung 16 voneinander getrennt sind. Wie die Zeichnung zeigt, ist die Kathode 8 vertikal angeordnet, so daß die einzelnen Substrate 11, 11',... bei der Bewegung in Pfeilrichtung A gleichmäßig beschichtet werden. Anschließend bewegt sich die Substrathalterung 10 weiter bis in die Partie II der Prozeßkammer 4, wobei die Substrate 11, 11',... mit einer weiteren Schicht versehen werden, da sie sich sämtlich an der Kathode 9 vorbeibewegen. Wenn der Substrathalter 10 die strichliert angedeutete Position erreicht hat, dann wird durch Umschalten der Drehvorrichtung der Rollen 12, 12',... die Bewegung in Pfeilrichtung B eingeleitet, d. h., daß der Substrathalter 10 in den Abschnitt I der Prozeßkammer 4 zurückbewegt wird und von hier aus durch die, während des gesamten Beschichtungsprozesses offene Schleuse 13 bis in die strich-punktiert dargestellte Position in der Vorkammer 3, wobei eine dritte Schicht von der Kathode 8 auf die Substrate 11, 11',... aufgebracht wird. Der Substratträger 10 kann nun so lange zwischen der strich-punktierten und der strichlierten Position bzw. zwischen dem Abschnitt III und dem Abschnitt I hin- und herpendeln, bis die erforderlichen Schichten aufgetragen sind. Zum Ausschleusen des Substrathalters 10 wird die Schleuse 13 geschlossen, die Vorkammer 3 belüftet und die Schleuse 14 geöffnet.

Hinsichtlich feinoptischer Anwendungen sind grundsätzlich optische Mehrfachschicht-Systeme auf flachen Substraten, wie sie für Interferenz-Filter gebraucht werden, für Sputter-Prozesse prädestiniert. Über ein Schleusenventil 14 gelangt der Substratträger 10 in die Vorkammer 3.

Hier wird in wenigen Minuten mit leistungsstarken Pumpen 5, 6, 7 das notwendige Prozeßvakuum erreicht. Nun kann die Schleuse 13 zur Prozeßkammer 4 geöffnet werden. Zur Beschichtung eines Mehrschicht-Systems aus einem hochbrechenden und einem niederbrechenden Material wird nun der Substratträger 10 im Wechsel an den beiden BeschichtungsStationen gleichmäßig vorbeibewegt. Auf diese Weise entsteht ein Paket aus beliebig vielen Einzelschichten, deren Dicke über die Sputterleistung und die Geschwindigkeit des Substratträgers 10 regelbar ist.

Als Auslegungsbeispiel sei ein Schicht-System mit 15 Einzelschichten zugrundegelegt. Bei einer Substratträgergröße von 40 x 40 cm beträgt die Beschichtungsleistung ca. 1 m²/h. Das heißt die Zykluszeit für das Beschichten eines Trägers 10 beträgt ca. 10 Minuten. Mit dieser Beschichtungsleistung ist die beschriebene Sputteranlage einer konventionellen Aufdampf-Anlage (batch-coater) überlegen. Bei er beschriebenen Sputteranlage handelt es sich um eine Einzweck-Anlage, die vorzugsweise für das Beschichten von flachen Substraten mit optischen Vielschicht-Systemen konzipiert ist.

## Patentansprüche

1. Vorrichtung zum Beschichten mittels Kathodenzerstäubung von im wesentlichen flachen Substraten (11, 11',...), vorzugsweise von optischen Elementen,
mit mindestens einer evakuierbaren Vorkammer (3) und mindestens einer mit dieser über eine Schleuseneinrichtung (13) verbundene Prozeßkammer (4) und
mit mehreren in der Prozeßkammer (4) angeordneten Beschichtungsquellen (8, 9) und
mit einer Vorrichtung (12, 12',...) zum Transportieren der Substrate (11, 11',...) von einer Bereitstellungsstation (15) durch die Vorkammer (3) in die Prozeßkammer (4) und aus der Prozeßkammer (4) zurück durch die Vorkammer (3) zur Bereitstellungsstation (15),
mit einer Einrichtung zum Umschalten der Bewegungsrichtung der die Substrate (11, 11',...) transportierenden Vorrichtung (12, 12',...) um zwischen dem Einschleusen und dem Ausschleusen der Substrate ein mehrmaliges Passieren der Substrate (11, 11',...) (im sogenannten Dual-Multipass-Mode) der längs des Substrattransportweges in der Prozeßkammer (4) angeordneten Beschichtungsquelllen (8, 9) zu bewirken.

2. Vorrichtung nach Anspruch 1, **dadurch gekennzeichnet**, daß die Länge der Prozeßkammer (4) etwa doppelt so groß bemessen ist, wie die Länge der Vorkammer (3).

3. Vorrichtung nach den Ansprüchen 1 und 2, **dadurch gekennzeichnet**, daß die Vorkammer mit einer ersten Schleuse (14) zum Einschleusen der Substrate (11, 11',...) und mit einer dieser Schleuse (14) gegenüberliegenden zweiten Schleuse (13) für das Umschleusen der Substrate (11, 11',...) von der Vorkammer (3) in die Prozeßkammer (4) versehen ist.

4. Vorrichtung nach den vorhergehenden Ansprüchen, **dadurch gekennzeichnet**, daß die Prozeßkammer (4) zwei quer zur Transporteinrichtung (A, B) angeordneten Kathoden (8, 9) aufweist, wobei die erste Kathode (8) sich am Anfang des ersten Abschnitts (I) und die zweite Kathode (9) sich am Anfang des zweiten Abschnitts (II) der Prozeßkammer (4) befindet.

5. Vorrichtung nach Anspruch (4), **dadurch gekennzeichnet**, daß die beiden Abschnitte (I und II) etwa gleich lang bemessen sind und durch eine Blende (16) voneinander getrennt sind, wobei die Blende (16) einen Durchlaß für den Substrathalter (10) aufweist.
